# EUROPEAN PATENT SPECIFICATION

(11) **EP 1 666 645 B1**
(45) Date of publication and mention of the grant of the patent: **19.06.2019**
(21) Application number: 04747456.4
(22) Date of filing: 07.07.2004
(51) Int. Cl.: C30B 29/36, H01L 21/304, H01L 21/336, H01L 29/78, H01L 21/02, H01L 21/314, H01L 29/16

(54) **METHOD FOR PRODUCING AND CLEANING A SILICON CARBIDE PRODUCT**
HERSTELLUNGSVERFAHREN UND REINIGUNG EINES SILICIUMCARBIDPRODUKTS
PROCEDE D'ÉLABORATION ET DE NETTOYAGE D'UN PRODUIT EN CARBURE DE SILICIUM

(30) Priority: 29.07.2003 JP 2003281801
(43) Date of publication of application: 07.06.2006
(73) Proprietor: Admap, Inc., Tamano-shi, Okayama 706-0014 (JP); Mitsui Engineering & Shipbuilding Co., Ltd., Chuo-ku Tokyo 104-8439 (JP); Ohmi, Tadahiro, Sendai-shi Miyagi-ken 980 (JP)
(72) Inventor: OHMI, Tadahiro, Aoba-ku, Sendai-shi, Miyagi 9800813 (JP); TERAMOTO, Akinobu, Miyagi 983-0037 (JP); SANO, Sumio, Okayama 7006-0021 (JP)
(74) Representative: Glawe, Delfs, Moll
(86) International application number: PCT/JP2004/009990
(87) International publication number: WO 2005/010244

(56) References cited:
- JP-A- 11 008 216
- JP-A- 2003 086 792
- US-A1- 2002 005 213
- KOO S-M ET AL: "Ferroelectric Pb(Zr,Ti)O3/Al2O3/4H-SiC diode structures" APPLIED PHYSICS LETTERS, AIP, AMERICAN INSTITUTE OF PHYSICS, MELVILLE, NY, vol. 81, no. 5, 29 July 2002 (2002-07-29), pages 895-897, XP012033127 ISSN: 0003-6951
- CHINONE Y. ET AL: 'Applications of high purity SiC prepared by chemical vapor deposition' AMORPHOUS AND CRYSTALLINE SILICON CARBIDE II vol. 43, 1989, pages 198 - 206, XP000617080
- DE VASCONCELOS E.A. ET AL: 'Potential of high-purity polycrystalline silicon carbide for thermistor applications' JAPANESE JOURNAL OF APPLIED PHYSICS vol. 37, no. 9A, 15 September 1998, pages 5078 - 5079, XP002211060

## Description

### Technical Field:

This invention relates to a silicon carbide product and, in particular, relates to silicon carbide for use in a semiconductor device or a structure, such as a member for manufacturing a semiconductor device and a method of manufacturing such silicon carbide.

### Background Art:

Generally, silicon carbide has excellent heat resistance and thus is used as a member for manufacturing a semiconductor device, such as a furnace core tube, a liner tube, a carrying tray, or a wafer boat. Further, it is known that silicon carbide forms a semiconductor device itself by the use of its semiconductor-like properties.

When silicon carbide is used as a member for manufacturing semiconductor device, it is necessary to prevent contamination of a semiconductor wafer or the like processed by such a member. Therefore, the silicon carbide forming the semiconductor device manufacturing member is periodically cleaned with hydrofluoric acid, pure water, or the like. In order to stably carry out such periodic cleaning in a short time, Japanese Unexamined Patent Application Publication (JP-A) No. H06-128036 (hereinafter referred to as reference document 1) proposes that the surface roughness, Rmax, of a silicon carbide member for manufacturing a semiconductor device be set to 3.2S or less. On the other hand, Japanese Unexamined Patent Application Publication (JP-A) No. H11-8216 (hereinafter referred to as reference document 2) proposes that a member for manufacturing a semiconductor device is made of silicon carbide be subjected to a heat treatment in a high temperature oxygen atmosphere to thereby form a silicon oxide film at the surface thereof and then the silicon oxide film at the surface is dissolved and removed by hydrofluoric acid. Further, reference documents 1 and 2 respectively disclose that silicon carbide is cleaned with dilute hydrofluoric acid (HF 7%) and that cleaning with dilute HF (HF 5%) is carried out after oxidizing the surface.

Further, as a method of forming a semiconductor device by the use of silicon carbide, Japanese Unexamined Patent Application Publication (JP-A) No. 2003-86792 (hereinafter referred to as reference document 3) discloses a method of forming a field-effect transistor. Specifically, reference document 3 points out that the electron mobility can be improved by forming a gate insulating film of a field-effect transistor on a silicon carbide region and then applying a heat treatment at a temperature in the range of 900 to 1000°C in an atmosphere containing water for a predetermined time. Further, reference document 3 also describes carrying out cleaning with dilute HF before the growth of the gate oxide film or the like, or carrying out RCA cleaning that combines NH₄OH+H₂O₂ and HCl+H₂O₂.
US 2002/0005213A1 discloses a sintered silicon carbide product which is cleaned by a combination of various cleaning processes in addition to an acid cleaning process.
Investigation of aluminium nitride grown by metal-organic chemical-deposition on silicon carbide (J. Appl. Phys., September 15, 1997, pages 2990 to 2995) discloses a cleaning process comprising among others a standard RCA sequence.

However, reference documents 1 to 3 only disclose cleaning the silicon carbide and discuss nothing about the surface condition of the silicon carbide after the cleaning. In other words, these reference documents 1 to 3 disclose nothing about the kind of impurities remaining on the surface of the silicon carbide after the cleaning according to the normal technique and the impurity concentration thereof. Further, although reduction in contamination and defect is essential for forming a semiconductor element by the use of silicon carbide, reference documents 1 to 3 suggest nothing about an optimal value of contamination amount etc. on silicon carbide or a contamination amount adjusting method and, therefore, under the circumstances, it is difficult to realize the theoretical properties of silicon carbide.

Therefore, it is an object of this invention to provide silicon carbide suitable for a semiconductor device or a member for manufacturing the semiconductor device.

It is another object of this invention to provide a cleaning method for obtaining the foregoing silicon carbide.

It is still another object of this invention to provide a product using silicon carbide with a low impurity concentration.

### Disclosure of the Invention:

These objects are achieved by a method of manufacturing a silicon carbide product according to claim 1; the dependent claims are related to further developments of the invention.

### Brief Description of the Drawings:

Fig. 1 is a diagram showing evaluation results of cleaning according to conventional silicon carbide cleaning methods;
Fig. 2 is a diagram showing Fe removal effects on the surface of silicon carbide according to cleaning methods of this invention;
Fig. 3 is a diagram showing an Fe removal effect on silicon carbide by the use of an aqueous solution (SPM) containing sulfuric acid (97%) and hydrogen peroxide (30%) which is used in this invention;
Fig. 4 is a diagram showing an Ni removal effect on the silicon carbide by the use of the aqueous solution (SPM) used in Fig. 3;
Fig. 5 is a diagram showing a Cu removal effect on the silicon carbide by the use of the aqueous solution (SPM) used in Figs. 3 and 4;
Fig. 6 is a diagram for explaining the effect of this invention when the silicon carbide is cleaned by the use of the aqueous solution (SPM) containing sulfuric acid (97%) and hydrogen peroxide (30%);
Fig. 7 is a flowchart showing the case where this invention is applied to the fabrication of a MOSFET having a silicon carbide substrate;
Fig. 8 is a sectional view showing a process of fabricating the MOSFET according to the flowchart of Fig. 7;
Fig. 9 is a sectional view showing a process performed subsequently to the process shown in Fig. 8;
Fig. 10 is a sectional view showing a process performed after the process shown in Fig. 9;
Fig. 11 is a sectional view for explaining a process performed next to the process shown in Fig. 10;
Fig. 12 is a sectional view for explaining a process performed after the process shown in Fig. 11;
Fig. 13 is a sectional view showing a post-process of Fig. 12;
Fig. 14 is a sectional view showing a process performed after the process shown in Fig. 13;
Fig. 15 is a flowchart for explaining the case where a silicon carbide dummy wafer is fabricated by the use of this invention;
Fig. 16 is a diagram showing a process of fabricating the silicon carbide dummy wafer according to the flowchart shown in Fig. 15;
Fig. 17 is a diagram for explaining a process performed after the process shown in Fig. 16;
Fig. 18 is a diagram showing a process performed subsequently to the process shown in Fig. 17; and
Fig. 19 is a diagram showing a final process of the silicon carbide dummy wafer fabrication processes.

### Best Mode for Carrying Out the Invention:

At first, the circumstances of this invention will be described.

According to knowledge of the present inventors, it often occurs that the theoretical properties of silicon carbide are not obtained in a semiconductor device using the silicon carbide and that the theoretical properties are not obtained also in a semiconductor device of silicon or the like manufactured by using a semiconductor device manufacturing silicon carbide member, and it has been found that such variation in properties is caused by the metal impurity concentration on the surface of the silicon carbide.

Particularly, a silicon carbide or silicon semiconductor device such as a field-effect transistor or the like is adversely affected by the impurity concentration on the surface of silicon carbide and therefore cannot achieve the theoretical properties.

Based on such knowledge, this invention provides an impurity concentration on the surface of silicon carbide that can eliminate the adverse influence and a cleaning method that can realize such an impurity concentration.

Specifically, according to experiments by the present inventors, it has been found that mainly iron (Fe) and an iron alloy remain as impurities on the surface of silicon carbide even if cleaned and that when the concentration of those impurities is 1×10¹¹ (atoms/cm²) or less, there is obtained a suitable semiconductor device having the properties quite close to the theoretical value.

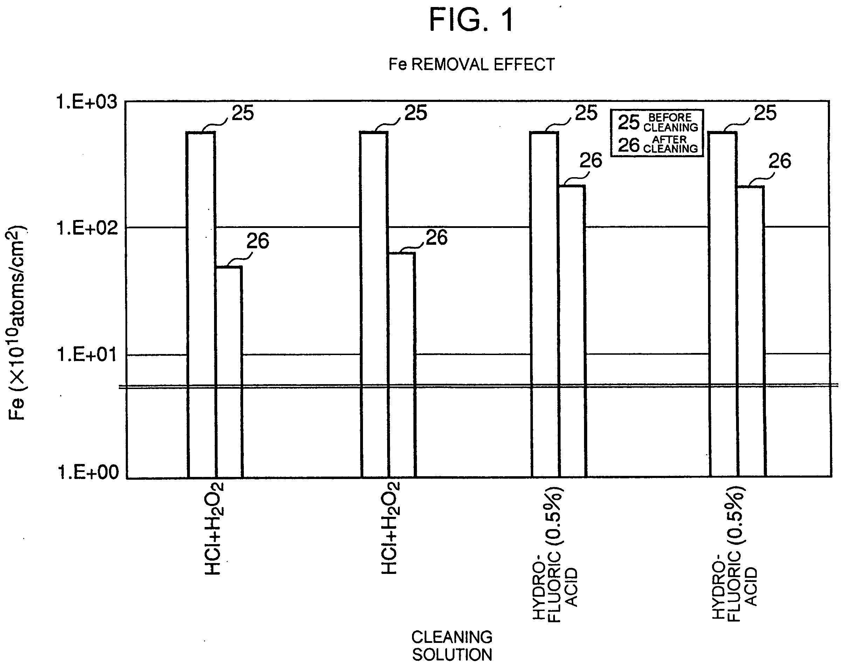

Referring here to Fig. 1, there are shown impurity (Fe) concentrations before and after cleaning in the case where silicon carbide is cleaned according to conventional cleaning methods. Herein, the axis of ordinates is given graduations of 1.E+00; 1.E+01; 1.E+02; and 1.E+03 in terms of (×10¹⁰ atoms/cm²) and these graduations respectively show concentrations of 1; 1×10¹; 1×10²; and 1×10³ with respect to (×10¹⁰ atoms/cm²). On the other hand, on the axis of abscissas, two cleaning results using HCl+H₂O₂ according to the conventional cleaning method and two cleaning results 26 using hydrofluoric acid (0.5%) according to the conventional cleaning method are shown along with impurity concentrations 25 before the cleaning. Table 1 below shows the removal ratios of iron along with the contents of cleaning when such cleaning is carried out on silicon carbide (SiC). As shown in Table 1 below and Fig. 1, it is understood that the concentrations of the metal impurities (iron or iron compound) according to the conventional cleaning methods are far larger than 1×10¹¹ (atoms/cm²) found in this invention.

**Table 1**

| Iron Removal Ratios on SiC for Respective Chemical Solutions | | | | |
|---|---|---|---|---|
| Before Cleaning | After Cleaning | Removal Ratio (%) 100 -After Cleaning/ Before Cleaning × 100 | Cleaning Solution | Cleaning Contents |
| × 10¹⁰atmos/cm² | | | | |
| 609 | 52 | 91 | HCl+H₂O₂ | HPM (HCl: H₂O₂ : |
| | | | | H₂O=1:1:6 92°C)for 10 minutes → Rinse for 10 minutes |
| 641 | 65 | 90 | HCl+H₂O₂ | HPM (HCl: H₂O₂: |
| | | | | H₂O=1:1:6 92°C) for 10 minutes → Rinse for 10 minutes |
| 661 | 230 | 65 | Hydrofluoric Acid (0.5%) | Hydrofluoric Acid (0.5%) for 10 minutes → Rinse for 10 minutes |
| 581 | 218 | 62 | Hydrofluoric Acid (0.5%) | Hydrofluoric Acid (0.5%) for 10 minutes → Rinse for 10 minutes |

Further, when manufacturing a semiconductor device having a gate oxide film, dilute HF (0.5%) cleaning or RCA cleaning that combines NH₄OH+H₂O₂ and HCl+H₂O₂ is carried out before the growth of the gate oxide film, but the impurity concentration cannot be reduced to the foregoing 1×10¹¹ (atoms/cm²) or less even by the RCA cleaning.

This invention makes it clear that surface metal impurities including iron can be removed to 1×10¹¹ (atoms/cm²) or less by cleaning silicon carbide by the use of hydrofluoric acid or hydrochloric acid having a predetermined or more concentration or by the use of a liquid containing sulfuric acid and a hydrogen peroxide solution.

Hereinbelow, an embodiment of this invention will be described with reference to the drawings.

Table 2 below shows cleaning solutions and the iron removal ratios when silicon carbide (SiC) is cleaned with the respective cleaning solutions, along with the cleaning conditions. As shown in Table 2, the iron removal ratio is calculated in terms of 100 - (after-cleaning impurities (atoms/cm²) / before-cleaning impurities (atoms/cm²)) × 100. As clear from Table 2, when silicon carbide is cleaned for 10 minutes with the cleaning solution (SPM) containing sulfuric acid (97%) and a hydrogen peroxide solution (37%) and then rinsed for 10 minutes, the iron removal ratio is about 100%, while, it is 98 to 99% with the cleaning solution of hydrofluoric acid (50%) and it is 98% with the cleaning solution of hydrochloric acid (36%).

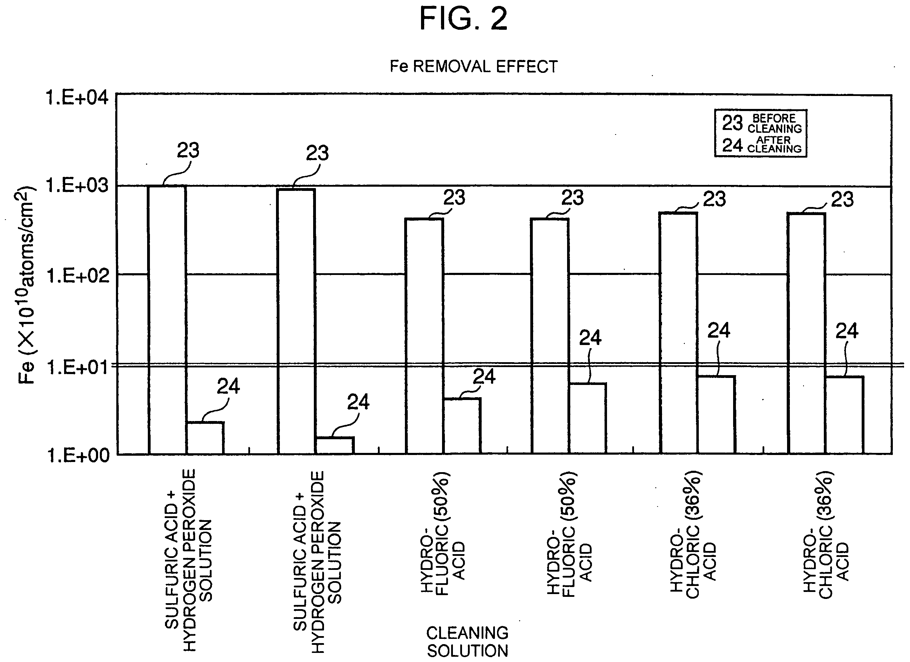

Fig. 2 shows the Fe removal effects of the respective cleaning solutions on the surface of the silicon carbide corresponding to Table 2. As shown in Fig. 2, it is understood that Fe on the surface of the silicon carbide can be reduced to 1×10¹¹ (atoms/cm²) or less by the cleaning using each of the foregoing cleaning solutions. As shown in Fig. 2 and Table 2, the aqueous solution containing sulfuric acid (97%) and hydrogen peroxide (30%), among the foregoing cleaning solutions, is particularly excellent in Fe removal effect.

**Table 2**

| Iron Removal Ratios on SiC for Respective Chemical Solutions | | | | |
|---|---|---|---|---|
| Before Cleaning | After Cleaning | Removal Ratio (%) 100 -After Cleaning/ Before Cleaning × 100 | Cleaning Solution | Cleaning Contents |
| × 10¹⁰ atoms/cm² | | | | |
| 1023 | 2 | 100 | Sulfuric Acid + Hydrogen Peroxide Solution | SPM for 10 minutes → Rinse for 10 minutes |
| 952 | 2 | 100 | Sulfuric Acid + Hydrogen Peroxide Solution | SPM for 10 minutes → Rinse for 10 minutes |
| 430 | 4 | 99 | Hydrofluoric Acid (50%) | Hydrofluoric Acid (50%) for 10 minutes → Rinse for 10 minutes |
| 419 | 7 | 98 | Hydrofluoric Acid (50%) | Hydrofluoric Acid (50%) for 10 minutes → Rinse for 10 minutes |
| 484 | 8 | 98 | Hydrochloric Acid (36%) | Hydrochloric Acid (36%) for 10 minutes → Rinse for 10 minutes |
| 484 | 8 | 98 | Hydrochloric Acid (36%) | Hydrochloric Acid (36%) for 10 minutes → Rinse for 10 minutes |

Table 3, Table 4, and Table 5 show the results of an experiment by the use of a metal impurity segregation evaluation apparatus. Herein, measurement is made of impurity distributions after putting a solution containing Fe, Ni, and Cu on a curved silicon carbide (SiC) wafer and segregating them, and impurity distributions after cleaning the impurity-segregated wafer by the cleaning method according to this invention. In this example, the cleaning is carried out using an aqueous solution (SPM) with a pH of 4 or less containing sulfuric acid (97%) and a hydrogen peroxide solution (30%) and the Fe, Ni, and Cu removal effects on the surface of silicon carbide after the cleaning are shown in association with distances from the center of the curved wafer. Further, Table 6 shows changes in the number of atoms of the respective components before and after the cleaning at the center of the surface of the silicon carbide. As clear from these tables, it is understood that Fe, Ni, and Cu remain only by 0.3, 0.2, and 0.16 (10¹⁰ atoms/cm²), respectively, on the surface of the silicon carbide cleaned by the SPM even at the curve center where the segregation reaches the largest amounts.

**Table 3**

| Distance | After Segregation | After SPM |
|---|---|---|
| -10 | - | - |
| 0 | 29.21 | 0.3 |
| 10 | 1.02 | 0.3 |
| 20 | 0.90 | 0.3 |
| 30 | 0.47 | 0.3 |
| 40 | 0.30 | 0.3 |
| 50 | 0.30 | 0.3 |
| 60 | 0.30 | 0.3 |
| 70 | - | - |

**Table 4**

| Distance | After Segregation | After SPM |
|---|---|---|
| -10 | - | - |
| 0 | 58.20 | 0.2 |
| 10 | 39.13 | 0.2 |
| 20 | 17.46 | 0.2 |
| 30 | 10.34 | 0.2 |
| 40 | 8.44 | 0.2 |
| 50 | 9.96 | 0.2 |
| 60 | 20.78 | 0.38 |
| 70 | - | - |

**Table 5**

| Distance | After Segregation | After SPM |
|---|---|---|
| -10 | - | - |
| 0 | 5.16 | 0.16 |
| 10 | 4.72 | 0.16 |
| 20 | 4.67 | 0.16 |
| 30 | 3.66 | 0.16 |
| 40 | 2.35 | 0.16 |
| 50 | 1.55 | 0.16 |
| 60 | 1.51 | 0.16 |
| 70 | - | - |

**Table 6**

| | Before Cleaning | After Cleaning |
|---|---|---|
| Fe | 29.21 | 0.3 |
| Ni | 58.20 | 0.2 |
| Cu | 5.16 | 0.16 |

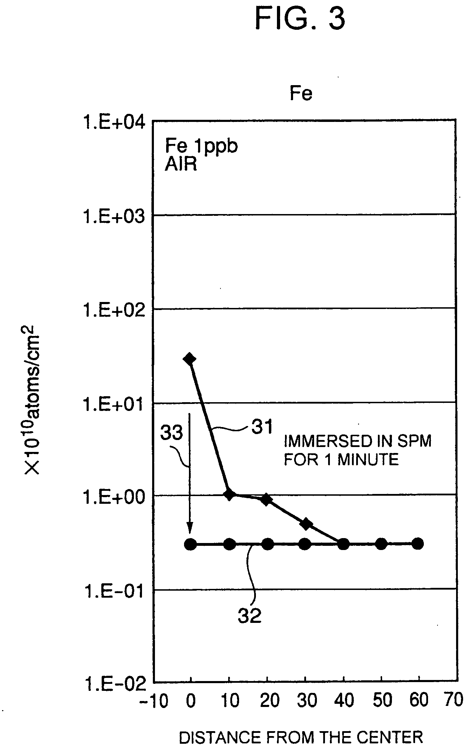

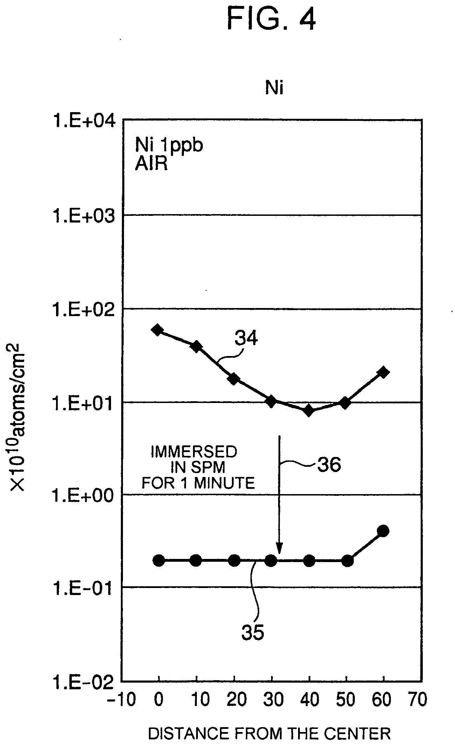

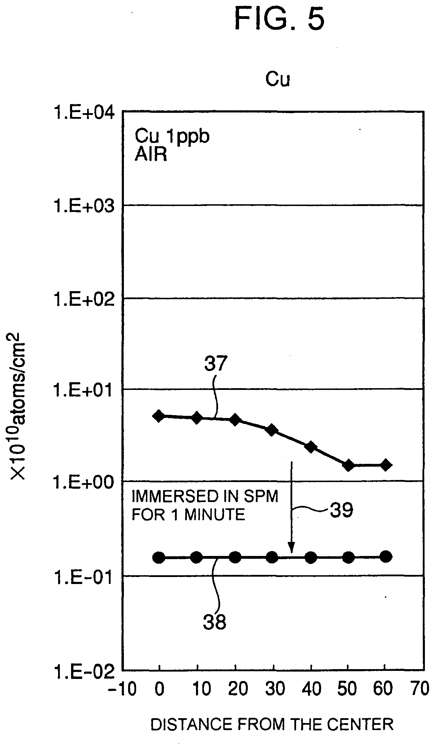

Further, Figs. 3, 4, and 5 respectively correspond to Tables 3, 4, and 5 and show the concentrations (10¹⁰ atoms/cm²) of Fe, Ni, and Cu on the surface of the silicon carbide. Figs. 3 to 5 show the Fe, Ni, and Cu removal effects after the cleaning with the aqueous solution (SPM) containing sulfuric acid (97%) and the hydrogen peroxide solution (30%), wherein the axis of abscissas represents distance from the center of the silicon carbide.

As shown in Figs. 3 to 5, in the case of the silicon carbide immersed in the foregoing SPM for one minute after the segregation, as compared with curved lines 31, 34, and 37 representing Fe, Ni, and Cu before the cleaning, Fe, Ni, and Cu are reduced even at the curve center portion where the segregation amounts are large, so as to be substantially equal to the amounts in the other regions after the cleaning as shown by curved lines 32, 35, and 38 representing Fe, Ni, and Cu after the cleaning. This demonstrates the large effect of the cleaning method according to this invention.

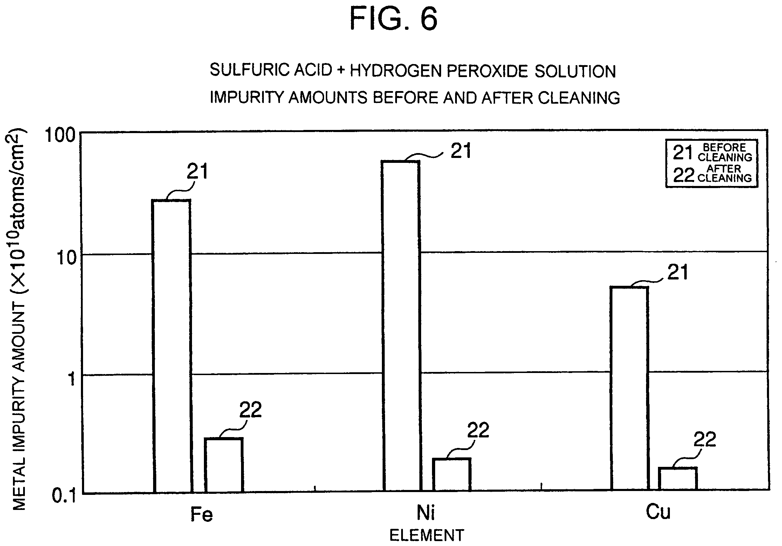

Referring now to Fig. 6, there are shown changes of the impurities Fe, Ni, and Cu at the center of the surface of the silicon carbide when the silicon carbide is cleaned by the use of the aqueous solution containing sulfuric acid (97%) and the hydrogen peroxide solution (30%). It is understood that Fe, Ni, and Cu, which were each 1^{∗}10¹¹ (atoms/cm²) or more before the cleaning as indicated bv reference numeral 21, each have reached 1^{∗}10¹⁰ (atoms/cm²) or less after the cleaning as indicated by reference numeral 22.

Now, description will be made about examples where the foregoing cleaning method is applied to the semiconductor device manufacture.

### (Example 1)

At first, a method according to the first example of this invention is applicable to the manufacture of a field-effect transistor (hereinafter abbreviated as MOSFET) having a gate, a source, and a drain. In this case, a single-crystal silicon carbide (SiC) wafer is prepared and this SiC wafer requires high cleanliness like Si.

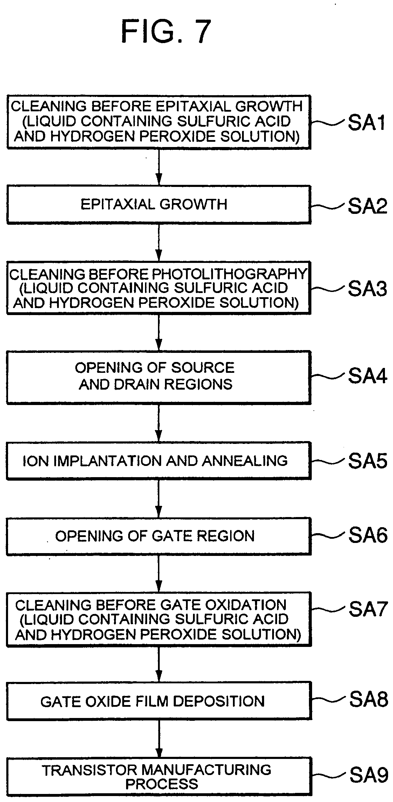

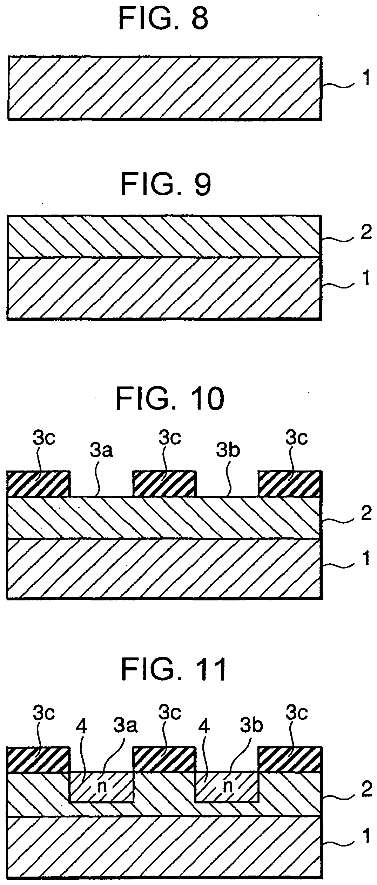

Fig. 7 is a flowchart of fabricating a MOSFET using a silicon carbide substrate and Fig. 8 to Fig. 14 are sectional views showing, in sequence, the fabrication processes of the MOSFET using the silicon carbide substrate.

Referring first to Figs. 7 and 8, a p-type 4H-SiC (0001) substrate 1 was prepared as silicon carbide and cleaning according to this invention was carried out before growing a p-type epitaxial layer on the surface of the silicon carbide substrate 1 (Fig. 7, step SA1). In this case, the cleaning method was such that sulfuric acid (97%) and a hydrogen peroxide solution (30%) were mixed in a volume ratio of 4:1 and the silicon carbide substrate 1 was immersed in this chemical solution for 10 minutes. After the immersion, the silicon carbide substrate 1 was rinsed with pure water for 10 minutes and dried with nitrogen blow.

As shown in Fig. 9, a p-type epitaxial layer 2 was grown after the cleaning (Fig. 7, step SA2).

After the growth of the epitaxial layer and before carrying out a photolithography process, the silicon carbide substrate 1 having the p-type epitaxial layer 2 was immersed for 10 minutes in a chemical solution in the form of an aqueous solution obtained by mixing sulfuric acid (97%) and a hydrogen peroxide solution (30%) in a volume ratio of 4:1 (Fig. 7, step SA3). Subsequently, after the immersion, the substrate 1 with the epitaxial layer 2 was rinsed with pure water for 10 minutes and dried with nitrogen blow.

After the cleaning, as shown in Fig. 10, source and drain regions were opened in a resist 3c by the photolithography process, thereby forming a source region opening portion 3a and a drain region opening portion 3b (Fig. 7, step SA4). Note that the resist 3c was actually continuous in a region other than the opening portions 3a and 3b.

Subsequently, as shown in Fig. 11, nitrogen was ion-implanted into the source and drain region opening portions 3a and 3b, thereby forming n-type source and drain regions 4 and 4. After the ion implantation, annealing was carried out for activation (Fig. 7, step SA5).

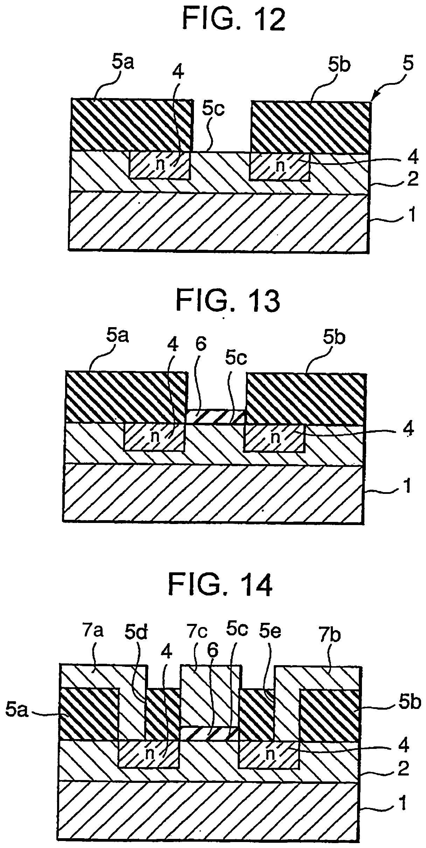

Then, after deposition of an oxide film 5 as an interlayer insulation film, as shown in Fig. 12, a gate region was opened in the oxide films 5a and 5b by a photolithography process, thereby forming a gate region opening portion 5c (Fig. 7, step SA6). The oxide films 5a and 5b were continuously formed at a portion other than the gate region opening portion 5c.

After the formation of the gate region opening portion 5c in Fig. 12, the foregoing cleaning according to this invention was carried out before deposition of a gate oxide film. The cleaning method was the same as that described before, i.e. the substrate shown in Fig. 12 was immersed for 10 minutes in a cleaning solution obtained by mixing sulfuric acid (97%) and a hydrogen peroxide solution (30%) in a volume ratio of 4:1 (Fig. 7, step SA7). After the immersion, the substrate was rinsed with pure water for 10 minutes and dried with nitrogen blow.

After the cleaning, as shown in Fig. 13, a gate oxide film 6 was formed by thermal oxidation (Fig. 7, step SA8).

After the formation of the gate oxide film 6, as shown in Fig. 14, electrodes 7a, 7b, and 7c were formed, thereby fabricating a MOSFET (step SA9). Herein, the oxide films 5a and 5b were continuously formed at a portion other than the electrodes 7a, 7b, and 7c, i.e. at a portion other than the opening portions 5c, 5d, and 5e.

As an electrode material usable in the MOSFET, it may be any of a metal film of Al, Mo, or the like, a silicide film of W-Si₂, Mo-Si₂, Ti-Si₂, or the like, and an n- or p-type silicon gate electrode. Hydrofluoric acid (45% or more) or HCl (35% or more) may be used as a cleaning solution instead of the liquid containing sulfuric acid and the hydrogen peroxide solution.

### (Example 2)

As the second example of this invention, there is shown the case where this invention is applied to the fabrication of a polycrystal silicon carbide wafer. Such a polycrystal silicon carbide wafer is mainly used as a dummy in the semiconductor device manufacturing process using a Si wafer and high cleanliness is also required for such a silicon carbide wafer used in the Si process.

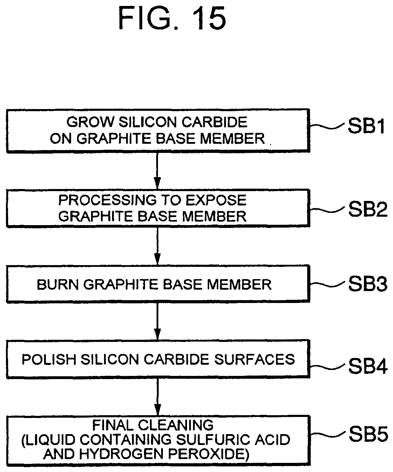

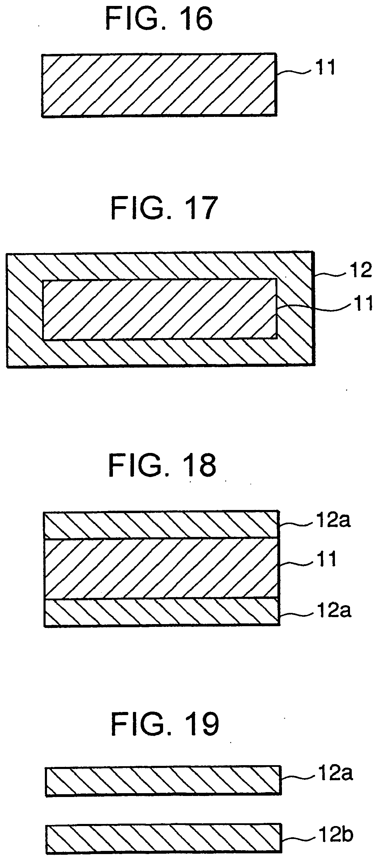

Fig. 15 is a flowchart of fabricating silicon carbide dummy wafers and Fig. 16 to Fig. 19 are diagrams showing the fabrication processes of the silicon carbide dummy wafers in sequence.

As shown in Figs. 15 and 16, a disk-shaped graphite base member 11 was first prepared and, then, as shown in Fig. 17, a silicon carbide 12 was grown by a CVD method so as to cover all surfaces of the graphite base member 11 (Fig. 15, step SB1).

Further, as shown in Fig. 18, the processing was performed to remove side portions of the silicon carbide 12 so that the graphite base member 11 was exposed (Fig. 15, step SB2).

Thereafter, the graphite base member 11 having the silicon carbides 12a and 12a formed on its both surfaces was burned in an oxygen atmosphere, thereby separating the silicon carbide wafers (Fig. 15, step SB3).

As shown in Fig. 19, the surfaces of the remaining silicon carbide wafers 12a and 12b were polished (step SB4). After the polishing, the silicon carbide wafers were immersed for 10 minutes in a chemical solution (cleaning solution) according to this invention obtained by mixing sulfuric acid (97%) and a hydrogen peroxide solution (30%) in a volume ratio of 4:1 (Fig. 15, step SB5). After the immersion, the wafers were rinsed with pure water for 10 minutes and dried with nitrogen blow, thereby fabricating the polycrystal silicon carbide wafers.

Also in this example, the same results were obtained even by using hydrofluoric acid (45% or more) or HCl (35% or more) instead of the liquid containing sulfuric acid and the hydrogen peroxide solution.

According to this invention, silicon carbide having high cleanliness can be obtained and, as a result, it becomes possible to obtain a semiconductor device with no need to consider degradation of the properties etc. due to impurities. Further, this invention, when applied to a semiconductor manufacturing member or the like, is advantageous in that it is also possible to prevent an adverse influence to a processing object caused by scattering of impurities, and so on.

In the foregoing examples, the description has been made about the case where the cleaning method according to this invention is applied to the manufacture of the semiconductor device. However, this invention is by no means limited thereto and is also applicable to semiconductor manufacturing members such as a diffusion furnace, and other structures. Further, this invention is also applicable to a surface treatment of a member formed with a silicon carbide thin film, and so on.

## Claims

1. A method of manufacturing a silicon carbide product which is either a p-type 4H SiC (0001) substrate of a single-crystal or a polycrystalline silicon carbide dummy wafer, consisting of:
a step of obtaining either the p-type 4H SiC (0001) substrate or the polycrystalline silicon carbide dummy wafer by a CVD method; and
a step of cleaning a surface of either the p-type 4H SiC (0001) substrate or the polycrystalline silicon carbide dummy wafer by immersing in a cleaning solution for 10 min to reduce surface metal impurities of the surface of the silicon carbide product to 1×10¹¹ (atoms/cm²) or less;
wherein said cleaning solution is obtained by mixing a sulfuric acid having a concentration of 97% and a hydrogen peroxide having a concentration of 30% in a volume ratio of 4:1 or by hydrofluoric acid which has a concentration of 45% or more or by hydrochloric acid which has a concentration of 35% or more.

2. The method according to claim 1, wherein said hydrofluoric acid has a concentration of 50%.

3. The method according to claim 1, wherein said hydrochloric acid has a concentration of 36%.

4. The method according to claim 1, wherein said liquid containing said sulfuric acid and said hydrogen peroxide solution has a pH of 4 or less.

5. The method according to claim 1, wherein the step of obtaining the polycrystalline silicon carbide wafer comprises:
a step of growing a silicon carbide layer on a whole of a disk-shaped graphite base member by a CVD method;
a step of removing side portions of the silicon carbide layer from the silicon carbide layer;
a step of separating the silicon carbide layer from the disk-shaped graphite base member by burning out the graphite base member in an oxygen atmosphere to obtain a pair of polycrystalline silicon carbide layers as the polycrystalline silicon carbide dummy wafer.

## Patentansprüche

1. Verfahren der Herstellung eines Siliziumcarbid-Produkts, das entweder ein P-Typ-SiC (0001)-Substrat oder ein Einkristall oder ein polykristalliner Siliziumcarbid-Dummy-Wafer ist, mit:
einem Schritt der Herstellung entweder des P-Typ-SiC (0001)-Substrats oder des polykristallinen Siliziumcarbid-Dummy-Wafers durch ein CVD-Verfahren und
einem Schritt der Reinigung einer Oberfläche des P-Typ-SiC (0001)-Substrats oder des polykristallinen Siliziumcarbid-Dummy-Wafers durch Eintauchen in eine Reinigungslösung für 10 Minuten zur Verminderung von Oberflächen-Metallverunreinigungen der Oberfläche des Siliziumcarbid-Produkts auf 1 x 10¹¹ (Atome/cm²) oder weniger,
wobei die Reinigungslösung erhalten wird durch Mischen einer Schwefelsäure mit einer Konzentration von 97 % und eines Wasserstoffperoxids mit einer Konzentration von 30 % in einem Volumenverhältnis von 4:1 oder durch Flusssäure mit einer Konzentration von 45 % oder mehr oder durch Salzsäure mit einer Konzentration von 35 % oder mehr.

2. Verfahren nach Anspruch 1, wobei die Flusssäure eine Konzentration von 50 % hat.

3. Verfahren nach Anspruch 1, wobei die Salzsäure eine Konzentration von 36 % hat.

4. Verfahren nach Anspruch 1, wobei die Flüssigkeit, die die Schwefelsäure und die Wasserstoffperoxid-Lösung enthält, einen pH von 4 oder weniger aufweist.

5. Verfahren nach Anspruch 1, wobei der Schritt der Herstellung des polykristallinen Siliziumcarbid-Wafers aufweist:
einen Schritt des Ziehens einer Siliziumcarbid-Schicht über eine Gesamtheit eines scheibenförmigen Graphit-Basiselements durch ein CVD-Verfahren,
einen Schritt der Entfernung von Seitenteilen der Siliziumcarbid-Schicht von der Siliziumcarbid-Schicht,
einen Schritt der Trennung der Siliziumcarbid-Schicht von dem scheibenförmigen Graphit-Basiselement durch Brennen des Graphit-Basiselements in einer Sauerstoffatmosphäre, um ein Paar von polykristallinen Siliziumcarbid-Schichten als den polykristallinen Siliziumcarbid-Dummy-Wafer zu erhalten.

## Revendications

1. Procédé de fabrication d'un produit en carbure de silicium qui est soit un substrat en SiC 4H (0001) de type p constitué d'un monocristal soit une tranche factice de carbure de silicium polycristallin, constitué de :
une étape consistant à obtenir soit le substrat en SiC 4H (0001) de type p soit la tranche factice de carbure de silicium polycristallin par un procédé de CVD ; et
une étape consistant à nettoyer une surface soit du substrat en SiC 4H (0001) de type p soit de la tranche factice de carbure de silicium polycristallin par immersion dans une solution de nettoyage pendant 10 min pour réduire les impuretés métalliques de surface de la surface du produit en carbure de silicium à 1 x 10¹¹ (atomes/cm²) ou moins ;
dans lequel ladite solution de nettoyage est obtenue par mélange d'un acide sulfurique ayant une concentration de 97 % et d'un peroxyde d'hydrogène ayant une concentration de 30 % en un rapport volumique de 4:1 ou par de l'acide fluorhydrique qui a une concentration supérieure ou égale à 45 % ou par de l'acide chlorhydrique qui a une concentration supérieure ou égale à 35 %.

2. Procédé selon la revendication 1, dans lequel ledit acide fluorhydrique a une concentration de 50 %.

3. Procédé selon la revendication 1, dans lequel ledit acide chlorhydrique a une concentration de 36 %.

4. Procédé selon la revendication 1, dans lequel ledit liquide contenant ledit acide sulfurique et ladite solution de peroxyde d'hydrogène a un pH inférieur ou égal à 4.

5. Procédé selon la revendication 1, dans lequel ladite étape consistant à obtenir la tranche de carbure de silicium polycristallin comprend :
une étape consistant à faire croître une couche de carbure de silicium sur la totalité d'un élément de base en graphite en forme de disque par un procédé de CVD ;
une étape consistant à enlever de la couche de carbure de silicium des parties latérales de la couche de carbure de silicium ;
une étape consistant à séparer la couche de carbure de silicium de l'élément de base en graphite en forme de disque par élimination par combustion de l'élément de base en graphite dans une atmosphère d'oxygène pour obtenir une paire de couches de carbure de silicium polycristallin en tant que tranche factice de carbure de silicium polycristallin.
